# EUROPÄISCHE PATENTSCHRIFT

(11) **EP 2 302 799 B1**
(45) Veröffentlichungstag und Bekanntmachung des Hinweises auf die Patenterteilung: **26.06.2013**
(21) Anmeldenummer: 10175030.5
(22) Anmeldetag: 02.09.2010
(51) Int. Cl.: H03K 17/96, H03K 17/972, F24C 7/08

(54) **Verfahren und Vorrichtung zur Bedienung eines Elektrogerätes**
Method and device for operating an electric device
Procédé et dispositif destinés à la commande d'un appareil électrique

(30) Priorität: 25.09.2009 DE 102009048494
(43) Veröffentlichungstag der Anmeldung: 30.03.2011
(73) Patentinhaber: E.G.O. ELEKTRO-GERÄTEBAU GmbH, 75038 Oberderdingen (DE)
(72) Erfinder: Baier, Martin, 76275 Ettlingen (DE)
(74) Vertreter: Patentanwälte Ruff, Wilhelm, Beier, Dauster & Partner

(56) Entgegenhaltungen:
- EP-A1- 1 873 609
- DE-A1- 10 229 629
- DE-A1-102006 030 550

## Beschreibung

### Anwendungsgebiet und Stand der Technik

Die Erfindung betrifft ein Verfahren zur Bedienung eines Elektrogeräts und eine entsprechende Vorrichtung.

Aus der DE 10 2006 054 764 A1 oder der EP 1 775 650 A2 sind Bedienvorrichtungen bekannt, bei denen ein an sich frei bewegbares Bedienelement auf eine Aufsetzstelle an einer Bedienfläche eines Elektro-Kochfeldes als Elektrogerät zur Drehbedienung aufsetzbar ist. Ist das Bedienelement auf die Aufsetzstelle aufgesetzt, so kann eine zugehörige Kochstelle-Eles-Elektro-Kochfeldes beispielsweise in seiner Leistung eingestellt werden. Wird das Bedienelement abgenommen, so kann am Funktionszustand der Kochstelle nichts verändert werden.

Aus der DE 102 29 629 A1 ist eine weitere Bedienvorrichtung bekannt mit einem auf eine Bedienfläche aufsetzbaren und abnehmbaren Bedienelement. Dabei sind unter dem abnehmbaren Bedienelement weitere Berührungsschalter angeordnet, um das Elektrogerät nah einem Abnehmen des Bedienelements weiter bedienen zu können, was ansonsten nicht möglich wäre. Aus der EP 1 873 609 A1 ist eine weitere ähnliche Bedieneinrichtung bekannt. Sie funktioniert im Prinzip ähnlich, wobei es hier möglich ist, mit dem abnehmbaren Bedienelement einen Hauptschalter für ein Elektrogerät zu realisieren, indem nämlich nach Abnehmen des Bedienknebels eine kurze Wartephase eingelegt wird und dann das Elektrogerät abgeschaltet wird.

Aus der DE 10 2006 030 550 A1 ist eine nochmals weitere Bedieneinrichtung bekannt mit einer abnehmbaren Bedieneinrichtung, welche nach Art einer Fernbedienung ausgebildet ist. Auf der Oberseite befindet sich eine Vielzahl von Berührfeldern. Eine Signalübertragung erfolgt mittels eines optischen Datenbusses sowie einer weiteren Übertragungseinrichtung, beispielsweise per Funk.

### Aufgabe und Lösung

Der Erfindung liegt die Aufgabe zugrunde, ein eingangs genanntes Verfahren sowie eine entsprechende Vorrichtung zur Bedienung eines Elektrogerätes zu schaffen, mit denen Probleme des Standes der Technik überwunden werden können und insbesondere eine komfortable und vielseitige Bedienung eines Elektrogerätes möglich ist bei geringem konstruktivem Aufwand für die Bedienvorrichtung.

Gelöst wird diese Aufgabe durch ein Verfahren mit den Merkmalen des Anspruchs 1 sowie eine Vorrichtung mit den Merkmalen des Anspruchs 12. Vorteilhafte sowie bevorzugte Ausgestaltungen der Erfindung sind Gegenstand der weiteren Ansprüche und werden im Folgenden näher erläutert. Manche der nachfolgenden Merkmale werden nur für das Verfahren oder nur für die Vorrichtung genannt. Sie sollen jedoch unabhängig davon sowohl für das Verfahren als auch für die Vorrichtung gelten können. Der Wortlaut der Ansprüche wird durch ausdrückliche Bezugnahme zum Inhalt der Beschreibung gemacht.

Das Elektrogerät weist mehrere Funktionseinheiten auf, beispielsweise bei einem Kochfeld mehrere Kochstellen, eine Steuerung, eine Bedienfläche und mindestens ein frei bewegbares Bedienelement zum Aufsetzen auf die Bedienfläche. Dazu ist an der Bedienfläche pro Funktionseinheit eine markierte Aufsetzstelle vorgesehen, auf welche das Bedienelement zur Bedienung aufgesetzt wird. Vorteilhaft sind weniger Bedienelemente als Aufsetzstellen vorgesehen, besonders vorteilhaft ein einziges Bedienelement. An bzw. unterhalb der Aufsetzstelle ist ein Sensor für einen Berührungsschalter vorgesehen, der insbesondere durch Auflegen eines Fingers betätigbar ist, sowie ein Sensor zur Erkennung der Drehung bzw. der Drehposition des Bedienelements im Zusammenwirken mit der Steuerung vorgesehen. Dies kann kapazitiv erfolgen wie in der DE 10 2006 054 764 A1 beschrieben, wobei ein Sensor an dem Bedienelement mit einem Finger berührt wird und dies dazu dient, dass der untere Sensor die Drehung bzw. Drehposition erkennt. Alternativ kann es gemäß der EP 1 775 650 A2 magnetisch erfolgen mit Hall-Sensoren.

Das Aufsetzen eines Bedienelements auf eine Aufsetzstelle wird erkannt durch einen der vorgenannten Sensoren und als Freigabe bzw. Selektieren der zugehörigen Funktionseinheit bzw. ihrer Eingabe ausgewertet. Ein anschließendes Bewegen bzw. Drehen des Bedienelements bewirkt ein Verändern des Funktionszustands der Funktionseinheit, beispielsweise eine Leistungsstufeneinstellung bei einer Kochstelle nach oben oder unten. Nach dem Abnehmen des Bedienelements von der Aufsetzstelle bleibt der zu diesem Zeitpunkt eingestellte Funktionszustand der entsprechenden Funktionseinheit erhalten, sie arbeitet also weiter und wird also nicht ausgeschaltet. Vorteilhaft wird der Funktionszustand sozusagen eingefroren und beispielsweise eine Leistungsverstellung kann erst wieder mittels eines aufgesetzten Bedienelements erfolgen.

So ist es möglich, dass bei einem Elektrogerät mit mehreren Funktionseinheiten einerseits weniger Bedienelemente benötigt werden, in einer vorteilhaften Ausgestaltung nur ein einziges Bedienelement. Dennoch können mit wenigen bzw. mit einem einzigen Bedienelement sämtliche Funktionseinheiten bedient bzw. eingestellt werden, bei einem einzigen Bedienelement allerdings nur nacheinander. Dies stellt aber in der Praxis kein Problem dar, da an einem Elektrogerät wie beispielsweise einem Kochfeld ohnehin in den allermeisten Fällen nur eine einzige Bedienperson arbeitet und somit ohnehin nur eine sequentielle Bedienung der Funktionseinheiten bzw. Kochstellen erfolgt.

In besonders vorteilhafter Ausgestaltung der Erfindung kann ein Auflegen eines Fingers auf eine Aufsetzstelle, auf der sich kein Bedienelement befindet, erkannt werden und die zugehörige Funktionseinheit ausgeschaltet werden. Dazu kann der vorgenannte Sensor für den Berührungsschalter ein kapazitiver Sensor sein, wie er beispielsweise aus der EP 859 467 A1 oder auch aus der vorgenannten DE 10 2006 054 764 A1 bekannt ist, der vorteilhaft auch so ausgebildet bzw. angesteuert werden kann, dass er nicht nur das Bedienelement bzw. dessen Drehung erkennen kann, sondern eben auch das Auflegen eines Fingers. Dann können in einer weiteren vorteilhaften Ausgestaltung der Erfindung die beiden vorgenannten Sensoren sogar in einem einzigen kombiniert sein. Der Vorteil hierbei liegt darin, dass zum Ausschalten einer Funktionseinheit, was unter Umständen sehr schnell und quasi intuitiv möglich sein soll, das Auflegen eines Fingers auf die Aufsetzstelle genügt, welche dann wie ein üblicher Berührungsschalter arbeitet. Somit braucht weder ein Bedienelement bewegt zu werden, noch möglicherweise in eine Funktion einer anderen Funktionseinheit eingegriffen zu werden.

In weiterer Ausgestaltung der Erfindung kann das Bedienelement Sensormittel aufweisen, die so ausgebildet sind, dass ihre Betätigung bei oder nach Aufsetzen des Bedienelements auf eine Aufsetzstelle von zugeordneten Sensoren erkannt wird, insbesondere auch einem der vorgenannten Sensoren. Solche Sensormittel an einem Bedienelement sind aus der vorgenannten DE 10 2006 054 764 A1 oder der EP 1 775 650 A2 bekannt und dort ebenfalls als kapazitiv arbeitende Berührungsschalter ausgebildet. Über eine kapazitive Kopplung kann ein Signal von einem Berührungsschalter bzw. einer Berührungsschalterfläche an dem Bedienelement auf einen Sensor unterhalb der Aufsetzstelle gekoppelt werden und somit kann das Betätigen des Sensormittels von unterhalb der Aufsetzstelle erkannt werden. Dadurch ist es möglich, dass nicht bereits mit aufgesetztem Bedienelement an der Aufsetzstelle die Funktionseinheit eingestellt oder verstellt werden kann, sondern erst das Sensormittel davor betätigt werden muss. Dies ist eine zusätzliche Sicherung gegen ungewolltes unabsichtliches Verstellen der Funktionseinheit.

In weiterer Ausbildung kann hier vorgesehen sein, dass nach Aufsetzen des Bedienelements auf eine Aufsetzstelle innerhalb einer vorgegebenen Zeit von maximal 10 Sekunden, vorzugsweise maximal 3 bis 5 Sekunden, eine Betätigung des Sensormittels erfolgen muss für eine nachfolgende Änderung des Funktionszustandes der zugehörigen Funktionseinheit. Erfolgt dies nicht in der vorgeschriebenen Zeit, so wird andernfalls die zugehörige Funktionseinheit entweder wieder gesperrt oder sogar, falls sie vorher aktiviert war, ausgeschaltet. Ein Abschalten kann jeweils durch Signale angekündigt oder begleitet sein.

In nochmals weiterer Ausgestaltung kann hier vorgesehen sein, dass bei einem auf eine Aufsetzstelle aufgesetzten Bedienelement die zugehörige Funktionseinheit ausgeschaltet wird, wenn das Sensormittel erneut betätigt wird, ohne dass das Bedienelement gedreht bzw. bewegt wird. Dadurch kann im Vergleich zum vorbeschriebenen Ausschalten einer Funktionseinheit mit Auflegen des Fingers auf die Aufsetzstelle auch ein Ausschalten erfolgen, ohne dass das Bedienelement weggenommen werden muss, um die Aufsetzstelle freizugeben. Es ist also möglich, dass nach Aufsetzen des Bedienelements auf eine Aufsetzstelle und Betätigen des Sensormittels kurz darauf jederzeit eine Einstellung an der Funktionseinheit möglich ist, ohne dass das Sensormittel erneut betätigt werden muss. Erst wenn es wieder betätigt wird, erfolgt eine Aktion, nämlich das Ausschalten der Funktionseinheit.

Bei einer alternativen, etwas einfacheren Ausgestaltung der Vorrichtung sowie vor allem des Bedienelements kann dieses ohne die vorbeschriebenen Sensormittel ausgebildet sein. So kann vor allem das Bedienelement einfacher gehalten sein und eventuell können auch weniger Sensoren an der Aufsetzstelle verwendet werden. In diesem Fall reicht das Aufsetzen des Bedienelements auf eine Aufsetzstelle sozusagen als Selektion der entsprechenden Funktionseinheit für eine nachfolgende Einstellung oder Verstellung durch Drehung bzw. Bewegung des Bedienelements. Ein Ausschalten kann dadurch erfolgen, dass das Bedienelement eben wieder weggenommen wird von der Aufsetzstelle und ein Finger daraufgelegt wird zum Ausschalten, wie zuvor beschrieben.

Weist das Bedienelement kein Sensormittel auf, so kann ebenfalls als Sicherheitsfunktion vorgesehen sein, dass nach Aufsetzen des Bedienelements auf eine Aufsetzstelle innerhalb einer vorgegebenen Zeit von maximal 10 Sekunden, vorzugsweise maximal 3 bis 5 Sekunden, eine Bewegung bzw. Drehung des Bedienelements erfolgen muss, ansonsten wird entweder die zugehörige Funktionseinheit oder das gesamte Elektrogerät abgeschaltet, wie es oben beschrieben worden ist. Auch hier kann natürlich wieder eine entsprechende Signalisierung erfolgen.

Einerseits kann in Ausgestaltung der Erfindung vorgesehen sein, dass eine Timer-Funktion integriert ist. Hierfür kann eine spezielle Aufsetzstelle vorgesehen sein, mit der bei darauf aufgesetztem Bedienelement ein Timer für die zuletzt mit dem Bedienelement eingestellte Funktionseinheit eingestellt werden kann.

Andererseits kann das Bedienelement auf der Aufsetzstelle der zugehörigen entsprechenden Funktionseinheit verbleiben, und durch Betätigen eines Umstell-Sensormittels, insbesondere eines speziellen Timer-Berührungsschalters an der Bedienfläche, wechselt die Funktion sozusagen in einen Timer-Modus und durch Bewegen bzw. Drehen des Bedienelements kann ein Timer eingestellt werden bzw. eine entsprechende Zeitvorgabe vorgenommen werden. Diese kann dann entweder nach einigen Sekunden als endgültige Timer-Vorgabe übernommen werden oder aber nach Betätigen eines Sensormittels am Bedienelement oder erneutem Betätigen des Umstell-Sensormittels für die Timer-Eingabe.

Bezüglich der konstruktiven Ausgestaltung des Bedienelements sowie der Bedienfläche bzw. der Aufsetzstelle wird zum einen explizit auf die DE 10 2006 054 764 A1 und die EP 1 775 650 A2 verwiesen. Dabei kann vorteilhaft zusätzlich zu Sensoren bzw. Sensorflächen für Erkennen von Aufsetzen bzw. Drehen des Bedienelements sowie Betätigen eines möglicherweise vorgesehenen Sensormittels ein zentrales kapazitives Sensorelement vorgesehen sein, welches ausschließlich Ausbildung und Funktion als Berührungsschalter zum Erkennen eines aufgelegten Fingers auf die Aufsetzstelle aufweist. So können sowohl dieser Sensor als auch die anderen für ihre jeweilige, spezielle Funktion besonders gut ausgebildet bzw. angepasst sein.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Draufsicht auf eine erfindungsgemäße Bedienvorrich- tung ohne Bedienelement,
- Fig. 2: eine Ausführungsform einer erfindungsgemäßen Bedien- vorrichtung samt Bedienelement in Schnittdarstellung und
- Fig. 3: die Bedienvorrichtung aus Fig. 1 mit aufgesetztem Bedien- element nach Fig. 2 in Draufsicht samt darauf aufgelegtem Finger.

### Detaillierte Beschreibung der Ausführungsbeispiele

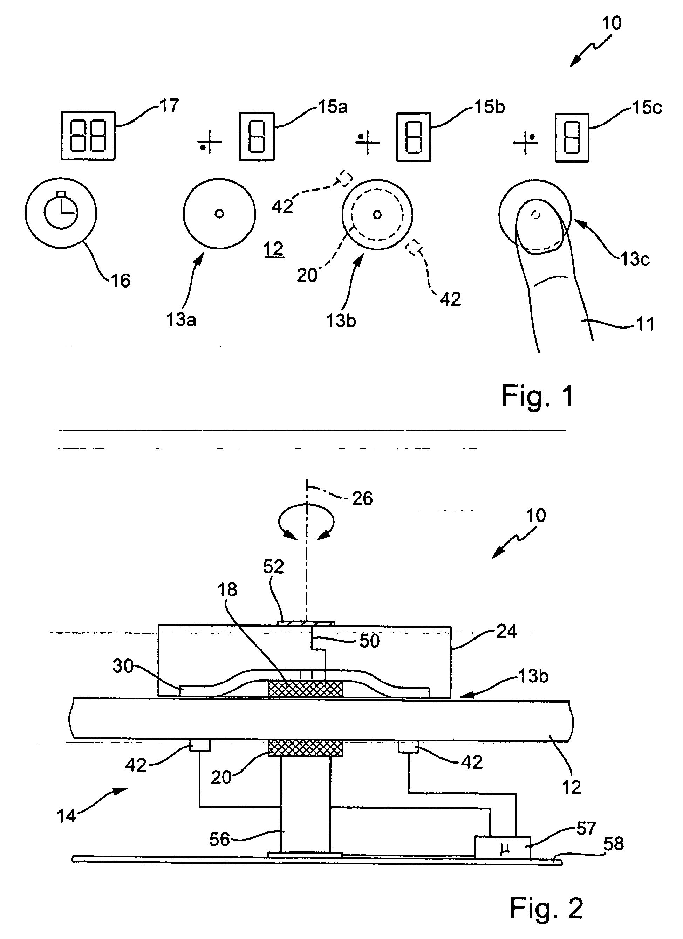

In Fig. 1 ist eine erfindungsgemäße Bedienvorrichtung 10 dargestellt an einer Bedienfläche 12, wobei die Bedienvorrichtung 10 Teil eines Elektrogerätes ist, beispielsweise eines Elektro-Kochfeldes, wobei dann die Bedienfläche 12 die Glaskeramik-Kochfeldplatte sein kann.

Die Bedienvorrichtung 10 weist an der Bedienfläche 12 drei Aufsetzstellen 13a bis 13c auf, die jeweils durch eine ringartige Kennzeichnung markiert sind und in der Mitte einen kleinen Ring aufweisen. Rechts oberhalb der Aufsetzstellen 13 sind Anzeigen 15a bis 15c angeordnet, die als Sieben-Segment-Anzeigen ausgebildet sind. Mit ihnen kann beispielsweise bei einem Elektro-Kochfeld als Elektrogerät und Kochstellen als Funktionseinheiten deren Leistungsstufe angezeigt werden. Links neben den Anzeigen 15 sind Symbole dargestellt, welche verdeutlichen, zu welcher der Kochstellen des Elektro-Kochfeldes die jeweilige Aufsetzstelle 13 gehört bzw. welche Kochstelle damit bedient werden kann. Links neben der Aufsetzstelle 13a ist ein Timerschalter 16 vorgesehen mit einer entsprechenden Markierung, der als üblicher kapazitiver Berührungsschalter ausgebildet ist. Oberhalb davon ist eine Timeranzeige 17 vorgesehen mit zwei Stellen, die wiederum als übliche Sieben-Segment-Anzeige ausgebildet ist.

An der mittleren Aufsetzstelle 13b ist ein unterer Magnet 20 vorgesehen sowie zwei Hall-Sensoren 42 zur Erkennung der Drehrichtung. Dies wird nachfolgend zu Fig. 2 noch näher erläutert, wobei der untere Magnet 20 einem sonst üblichen Sensorelement eines kapazitiven Berührungsschalters entspricht. Dies ist aus der EP 1 775 650 A2 bekannt. Rechts in Fig. 1 ist auf die Aufsetzstelle 13c ein Finger 11 aufgelegt. Auch dies wird nachfolgend zum Bedienverfahren noch näher erläutert.

Fig. 2 zeigt die Anordnung aus Fig. 1 im Schnitt. Ein Bedienelement 24 ist auf der Bedienfläche 12 der Bedienvorrichtung 10 vorgesehen, als Drehknebel ausgebildet und kann um eine Drehachse 26 gedreht werden. Die Lagerung erfolgt durch einen zentralen Magneten 18 im Bedienelement 24 sowie den gegenüberliegenden Magneten 20 unter der Bedienfläche 12. Oberhalb des Magneten 18 verläuft in dem Bedienelement 24 ein Blech- oder Metallstern 30. Dieser ist beispielsweise fünfarmig und ist derart mit dem Magneten 18 verbunden, dass die einzelnen Arme des Metallsterns 30 ebenfalls magnetisch sind. Mit Hall-Sensoren 42 unter der Bedienfläche 12 kann so auf bekannte Art und Weise die Drehstellung ermittelt werden, wie dies beispielsweise aus der EP 1 775 650 A2 bekannt ist, auf die diesbezüglich explizit verwiesen wird.

Der Magnet 18 ist mit einer gestrichelt dargestellten Verbindung 50 elektrisch leitfähig mit einem elektrisch leitfähigen flächigen Berührungssensor 52 auf der Oberseite des Bedienelements 24 verbunden. Diese Darstellung ist nur schematisch, es sind verschiedene Anordnungen von Berührungssensoren 52 an verschiedenen Stellen möglich sowie auch mehrere Berührungssensoren.

Der untere Magnet 20 ist über einen elastischen und elektrisch leitfähigen Kunststoffkörper 56 elektrisch mit einer Steuerung 57 auf einer Leiterplatte 58 verbunden. Mit dieser Steuerung 57 sind auch die Hall-Sensoren 42 verbunden.

Berührt nun eine Bedienperson den Berührsensor 52, so entsteht eine elektrische Verbindung zwischen dem Berührsensor und dem zentralen Magneten 18. Dies kann über kapazitive Kopplung zwischen den als elektrisch leitfähige Flächen wirkenden Magneten 18 und 20 sowie die elektrische Verbindung 56 an die Steuerung 57 gegeben werden. Diese kann also das Berühren eines der Berührsensoren erkennen durch die Bedienfläche 12 hindurch nach dem Funktionsprinzip eines kapazitiven Berührsensors, wie es beispielsweise in der EP 859 467 A1 oder der eingangs genannten EP 1 775 650 A2 beschrieben ist. Da sich das Bedienelement 24 stets um seine Mittelachse 26 dreht und sich somit die beiden Magnete 18 und 20 nicht auseinander bewegen, ist die Zuordnung in jeder Drehstellung gleich und die Erkennung der Berührung funktioniert immer. In diesem Fall ist also der Berührsensor 52 im Zusammenwirken mit dem Magneten 18 das oben genannte Sensormittel, und zwar als Berührungsschalter.

An welcher der gezeigten Stellen an dem Bedienelement 24 der Berührsensor 52 angebracht wird kann vom jeweiligen Verwendungszweck abhängen. Das Vorsehen des Berührsensors 52 in der Mitte weist den Vorteil auf, dass neben einer sehr guten separaten Betätigung ähnlich einem normalen Berührungsschalter ohne Drehbewegung auch für kleine Drehwinkel eine Betätigung bei gleichzeitiger Drehung möglich ist.

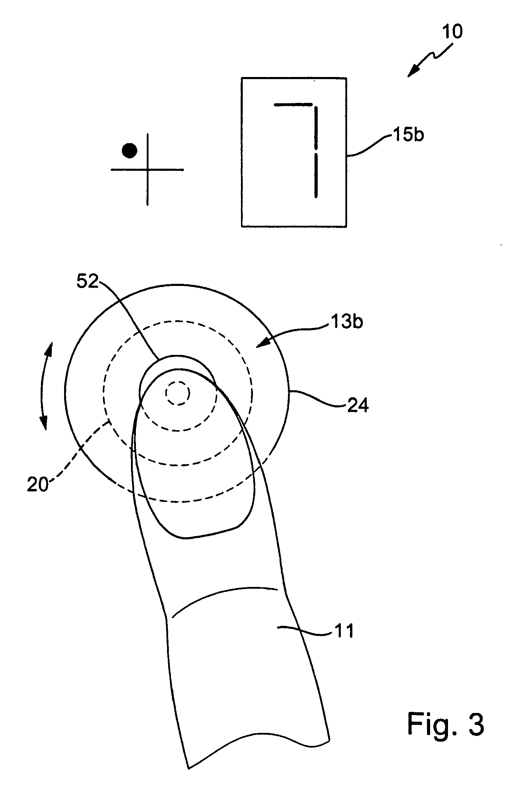

In Fig. 3 ist in Draufsicht dargestellt, wie das Bedienelement 24, welches das einzige der Bedienvorrichtung 10 ist, auf die Aufsetzstelle 13b aufgesetzt ist. Wie zuvor erläutert worden ist, kann das Aufsetzen des Bedienelements 24 auf die Aufsetzstelle 13b von der Bedienvorrichtung 10 bzw. der Steuerung 57 erkannt werden, beispielsweise weil die Hall-Sensoren 42 das Magnetfeld des Bedienelements 24 erfassen können oder am unteren Magnet 20 als kapazitives Sensorelement. Gemäß einer einfachen Ausgestaltung der Erfindung reicht bereits das Aufsetzen des Bedienelements 24 auf die Aufsetzstelle 13b, dass die entsprechende Kochstelle selektiert wird bzw. nun in ihrer Leistung verstellt werden kann. Dies erfolgt durch Drehen des Bedienelements 24 mit der Hand. Es ist an der Anzeige 15b dargestellt, dass nun die Leistungsstufe "7" eingestellt worden ist. Die entsprechende Kochstelle kann nun also entweder sofort betrieben werden mit der Leistungsstufe "7". Alternativ muss erst mit dem Finger 11 erneut der Berührungssensor 52 als Sensormittel betätigt werden, was über die kapazitive Kopplung an den Magneten 18 und 20 von der Steuerung 57 erkannt werden kann, damit der Betrieb startet.

Verbleibt nun das Bedienelement 24 auf der Aufsetzstelle 13b, so kann jederzeit durch Drehen in eine der beiden Richtungen die Leistungsstufe der entsprechenden zugehörigen Kochstelle verändert werden. Sollte in der Zwischenzeit eine andere Kochstelle ausgeschaltet werden weil sie nicht mehr benötigt wird, so kann beispielsweise gemäß Fig. 1 der Finger 11 auf die entsprechende Aufsetzstelle 13c bzw. über das darunter vorgesehene kapazitive Sensorelement in Form des entsprechenden unteren Magneten aufgesetzt werden. Dies erkennt die Steuerung 57 ebenfalls und kann dann die entsprechende Kochstelle ausschalten. Ein Ausschalten ist also ohne Verschieben des Bedienelements 24 bzw. überhaupt ohne dieses möglich. Dies erhöht sowohl die Bediensicherheit als auch den Bedienkomfort.

Soll die zu der Aufsetzstelle 13b zugehörige Kochstelle ausgeschaltet werden, so kann vorgesehen sein, dass dazu erneut der Berührungssensor 52 betätigt wird. Somit braucht also das Bedienelement 24 nicht entfernt zu werden, um einen Finger 11 direkt auf die Bedienfläche 12 auflegen zu können, wie zuvor beschrieben worden ist. Das Ausschalten einer zu einer Aufsetzstelle 13 zugehörigen Kochstelle kann also auf zwei Arten erfolgen.

Soll für die zu der Aufsetzstelle 13b zugehörige Kochstelle eine Timer-einstellung vorgenommen werden, so kann ein Finger 11 auf den Timerschalter 16 ganz links aufgelegt werden. Dazu kann beispielsweise die Timeranzeige 17 blinken als Zeichen dafür, dass nun eine Timer-Einstellung vorgenommen werden kann. Dann kann das auf der Aufsetzstelle 13b befindliche Bedienelement 24 entweder direkt gedreht werden, da die Steuerung 57 nun nach Betätigen des Timerschalters 16 in einem Timer-Einstellmodus ist und ein Drehen des Bedienelements ausschließlich eine Timer-Einstellung bewirkt und keine Leistungseinstellung. Durch Drehen des Bedienelements 24 kann also eine Timerzeit eingestellt werden und nach Einstellung beispielsweise durch Betätigen des Berührungssensors 52 bestätigt und übernommen werden. Für die Dauer der Timer-Einstellung kann auch beispielsweise die entsprechende Anzeige 15b der Aufsetzstelle 13b auf bestimmte Art und Weise leuchten, um noch einmal zu verdeutlichen, dass der Timer gerade für die entsprechende Kochstelle eingestellt wird. Dies muss aber nicht sein, da durch das Aufliegen des Bedienelements 24 ja eindeutig klar ist, um welche Aufsetzstelle 13 und somit um welche Kochstelle es sich handelt. Nach Übernahme der Timer-Einstellung schaltet die Steuerung 57 dann wieder in den normalen Modus zurück, bei dem ein Drehen des Bedienelements 24 eine Leistungsstufenänderung bewirkt.

Wie zuvor erläutert worden ist, können weitere Sicherheitsvorkehrungen eingebaut sein in das Bedienverfahren bzw. die Steuerung 57. So kann beispielsweise vorgesehen sein, dass nach Aufsetzen des Bedienelements 24 auf eine Aufsetzstelle 13 innerhalb einer Zeit von beispielsweise 5 bis 10 Sekunden entweder das Bedienelement gedreht werden muss oder aber der Berührungssensor 52 als Sensormittel betätigt werden muss, ansonsten erfolgt ein Fehlersignal oder ein Abschalten der entsprechenden Kochstelle oder des gesamten Gerätes. In weiterer Ausgestaltung einer Bedienvorrichtung 10 kann vorgesehen sein, dass keine separate Timeranzeige 17 vorgesehen ist, sondern die Anzeigen 15 dazu verwendet werden und entsprechend ausgebildet sind, insbesondere zweistellig ausgebildet sind. Dann kann direkt an der Aufsetzstelle 13 die Timer-Einstellung abgelesen werden.

Als nochmals weitere Sicherheitseinrichtung kann allgemein vorgesehen sein, dass nach Abnehmen des Bedienelements von einer Aufsetzstelle 13 zwar grundsätzlich deren Funktionseinstellung und Funktionszustand erhalten bleiben. Wird das Bedienelement 24 allerdings nicht innerhalb einer vorgegebenen Zeit von beispielsweise 10 Sekunden oder mehr auf eine andere Aufsetzstelle 13 aufgesetzt, so kann dies als Fehlerfall bzw. gewünschtes Ausschalten und Sichern des Geräts erkannt werden und das Gerät entsprechend ausgeschaltet werden. Damit ist beispielsweise für eine Kindersicherung sichergestellt, dass bei entferntem Bedienelement 24 zum einen nichts verstellbar ist und zum anderen das Gerät insgesamt ausgeschaltet ist.

## Patentansprüche

1. Verfahren zur Bedienung eines Elektrogerätes, wobei das Elektrogerät mehrere Funktionseinheiten, eine Bedienfläche (12) und mindestens ein frei bewegbares Bedienelement (24) aufweist zum Aufsetzen auf die Bedienfläche, wobei an der Bedienfläche (12) pro Funktionseinheit eine markierte Aufsetzstelle (13) zum Aufsetzen des Bedienelements (24) vorgesehen ist, wobei an oder unterhalb der Aufsetzstelle (13) ein Sensor (20) für einen Berührungsschalter (52) sowie ein Sensor (42) zur Erkennung der Drehung bzw. Drehposition des Bedienelements (24) vorgesehen sind, wobei das Aufsetzen eines Bedienelements (24) auf eine Aufsetzstelle (13) erkannt wird und als Einschalten bzw. Aktivieren der zugehörigen Funktionseinheit ausgewertet wird und ein anschließendes Drehen des Bedienelements (24) erkannt wird und ein Verändern des Funktionszustands der Funktionseinheit bewirkt, wobei nach Abnehmen des Bedienelements (24) von der Aufsetzstelle (13) der Funktionszustand der entsprechenden Funktionseinheit erhalten bleibt.

2. Verfahren nach Anspruch 1, **dadurch gekennzeichnet, dass** das Auflegen eines Fingers (11) auf eine Aufsetzstelle (13) ohne Bedienelement (24) darauf erkannt wird und die zugehörige Funktionseinheit ausschaltet.

3. Verfahren nach Anspruch 1 oder 2, **dadurch gekennzeichnet, dass** das Bedienelement (24) Sensormittel (52) aufweist, deren Betätigung bei Aufsetzen auf eine Aufsetzstelle (13) von zugeordneten Sensoren (20) darunter erkannt wird.

4. Verfahren nach Anspruch 3, **dadurch gekennzeichnet, dass** erst nach Betätigen des Sensormittels (52) eine Änderung eines Funktionszustands der zu der Aufsetzstelle (13) zugehörigen Funktionseinheit möglich ist bzw. freigegeben wird.

5. Verfahren nach Anspruch 3 oder 4, **dadurch gekennzeichnet, dass** nach Aufsetzen des Bedienelements (24) auf eine Aufsetzstelle (13) innerhalb einer vorgegebenen Zeit von maximal 10 Sekunden, vorzugsweise maximal 5 Sekunden, eine Betätigung des Sensormittels (52) erfolgen muss für eine nachfolgende Änderung des Funktionszustandes der zugehörigen Funktionseinheit, wobei andernfalls die zugehörige Funktionseinheit ausgeschaltet wird.

6. Verfahren nach einem der Ansprüche 3 bis 5, **dadurch gekennzeichnet, dass** durch erneutes Betätigen des Sensormittels (52) bei auf einer Aufsetzstelle (13) aufgesetztem Bedienelement (24) die zugehörige Funktionseinheit ausgeschaltet wird.

7. Verfahren nach einem der vorhergehenden Ansprüche, **dadurch gekennzeichnet, dass** das Elektrogerät ein einziges Bedienelement (24) aufweist, wobei vorzugsweise sämtliche Aufsetzstellen (13) für die Funktionseinheiten gleich ausgebildet sind.

8. Verfahren nach einem der vorhergehenden Ansprüche, **dadurch gekennzeichnet, dass** das Elektrogerät ein Kochfeld mit mehreren Kochstellen ist.

9. Verfahren nach einem der vorhergehenden Ansprüche, **dadurch gekennzeichnet, dass** nach Aufsetzen des Bedienelements (24) auf eine Aufsetzstelle (13) innerhalb einer vorgegebenen Zeit von maximal 10 Sekunden, vorzugsweise maximal 5 Sekunden, eine Bewegung bzw. Drehung des Bedienelements (24) erfolgen muss für eine nachfolgende Änderung des Funktionszustandes der zugehörigen Funktionseinheit, wobei andernfalls die zugehörige Funktionseinheit ausgeschaltet wird.

10. Verfahren nach einem der vorhergehenden Ansprüche, **dadurch gekennzeichnet, dass** mit einer Aufsetzstelle (13) und einem auf diese Aufsetzstelle (13) aufgesetzten Bedienelement (24) ein Timer für eine Funktionseinheit eingestellt wird, wobei vorzugsweise eine Aufsetzstelle (13) für eine Funktionseinheit durch Betätigen eines Umstell-Sensormittels, insbesondere eines Berührungsschalter (16) an der Bedienfläche (12), in einen Timermodus wechselt zur Eingabe einer Timervorgabe.

11. Verfahren nach einem der vorhergehenden Ansprüche, **dadurch gekennzeichnet, dass** nah Abnehmen des Bedienelements (24) von einer Aufsetzstelle (13) die Funktionseinstellung und der Funktionszustand erhalten bleiben, wobei für den Fall, dass das Bedienelement (24) nicht innerhald einer vorgegebenen Zeit, vorzugsweise 3 bis 20 Sekunden, auf eine andere Aufsetzstelle (13) aufgesetzt wird, dies als Fehlerfall bzw. gewünschtes Ausschalten und Sichern des Geräts erkannt wird und das Gerät entsprechend ausgeschaltet wird.

12. Vorrichtung zur Durchführung des Verfahrens nach einem der vorhergehenden Ansprüche, wobei das Elektrogerät mehrere Funktionseinheiten aufweist und die Vorrichtung eine Steuerung (57), eine Bedienfläche (12) und mindestens ein frei bewegbares Bedienelement (24) aufweist zum Aufsetzen auf die Bedienfläche, wobei an der Bedienfläche (12) pro Funktionseinheit eine markierte Aufsetzstelle (13) zum Aufsetzen des Bedienelements (24) vorgesehen ist, wobei an bzw. unterhalb der Aufsetzstelle (13) ein Sensor (20) für einen Berührungsschalter sowie ein Sensor (42) zur Erkennung der Drehung bzw. Drehposition des Bedienelements vorgesehen ist, wobei die Sensoren (20, 42) und die Steuerung (57) zum Erkennen des Aufsetzens eines Bedienelements (24) auf eine Aufsetzstelle (13) und zum Einschalten bzw. Aktivieren der zugehörigen Funktionseinheit ausgebildet sind und zum anschließenden Erkennen des Drehens des Bedienelements (24), um durch die Steuerung ein Verändern des Funktionszustands der Funktionseinheit zu bewirken, wobei nach Abnehmen des Bedienelements (24) von der Aufsetzstelle (13) der Funktionszustand der entsprechenden Funktionseinheit erhalten bleibt.

13. Vorrichtung nach Anspruch 12, **dadurch gekennzeichnet, dass** das Elektrogerät nur ein einziges Bedienelement (24) aufweist, wobei vorzugsweise sämtliche Aufsetzstellen (13) für die zugehörigen Funktionseinheiten gleich ausgebildet sind.

## Claims

1. A method for operating an electrical appliance, with the electrical appliance having a plurality of functional units, an operator control surface (12) and at least one freely movable operator control element (24) for mounting onto the operator control surface, with a marked mounting point (13) for mounting the operator control element (24) being provided in the operator control surface (12) for each functional unit, with a sensor (20) for a touch switch (52) and a sensor (42) for identifying the rotation or rotation position of the operator control element (24) being provided on or beneath the mounting point (13), with mounting of an operator control element (24) on a mounting point (13) being identified and evaluated as switch-on or activation of the associated functional unit and subsequent rotation of the operator control element (24) being identified and effecting a change in the functional state of the functional unit, with the functional state of the corresponding functional unit being maintained after the operator control element (24) is removed from the mounting point (13).

2. The method according to Claim 1, **characterized in that** the application of a finger (11) on a mounting point (13) without an operator control element (24) on it is identified and the associated functional unit is switched off.

3. The method according to Claim 1 or 2, **characterized in that** the operator control element (24) has sensor means (52), the operation of said sensor means being identified by associated sensors (20) beneath said mounting point, when said operator control element is mounted on a mounting point (13).

4. The method according to Claim 3, **characterized in that** a change in a functional state of the functional unit associated with the mounting point (13) is possible or is enabled only after operation of the sensor means (52).

5. The method according to Claim 3 or 4, **characterized in that** the sensor means (52) has to be operated within a prespecified time of at maximum 10 seconds, preferably at maximum 5 seconds, after the operator control element (24) is mounted on a mounting point (13), in order to effect a subsequent change in the functional state of the associated functional unit, with the associated functional unit otherwise being switched off.

6. The method according to any of the Claims 3 to 5, **characterized in that** the associated functional unit is switched off by again operating the sensor means (52) when an operator control element (24) is mounted on a mounting point (13).

7. The method according to any of the preceding Claims, **characterized in that** the electrical appliance has one single operator control element (24), with preferably all the mounting points (13) for the functional units being of identical design.

8. The method according to any of the preceding Claims, **characterized in that** the electrical appliance is a hob having a plurality of cooking points.

9. The method according to any of the preceding Claims, **characterized in that** the operator control element (24) has to be moved or rotated within a prespecified time of at maximum 10 seconds, preferably at maximum 5 seconds, after the operator control element (24) is mounted on a mounting point (13), in order to effect a subsequent change in the functional state of the associated functional unit, with the associated functional unit otherwise being switched off.

10. The method according to any of the preceding Claims, **characterized in that** a timer for a functional unit is adjusted together with a mounting point (13) and an operator control element (24) which is mounted on this mounting point (13), with a mounting point (13) for a functional unit preferably changing over to a timer mode by operation of a changeover sensor means, in particular a touch switch (16) on the operator control surface (12), for the purpose of inputting a timer prespecification.

11. The method according to any of the preceding Claims, **characterized in that** after removing the operator control element (24) from a mounting point (13) the functional adjustment and the functional state are maintained, and in case that the operator control element (24) is not mounted on another mounting point (13) within a prespecified time of preferably 3 to 20 seconds, an error or desired switching off and securing of the appliance being identified and accordingly the appliance is switched off.

12. An apparatus for carrying out the method according to any of the preceding claims, with the electrical appliance having a plurality of functional units and the apparatus having a control unit (57), an operator control surface (12) and at least one freely movable operator control element (24) for mounting onto the operator control surface, with a marked mounting point (13) for mounting the operator control element (24) being provided in the operator control surface (12) for each functional unit, with a sensor (20) for a touch switch and a sensor (42) for identifying the rotation or rotation position of the operator control element being provided on or beneath the mounting point (13), with the sensors (20, 42) and the control unit (57) being designed to identify mounting of an operator control element (24) on a mounting point (13) and for switching on or activating the associated functional unit, and for subsequently identifying the rotation of the operator control element (24), in order to effect a change in the functional state of the functional unit by the control unit, with the functional state of the corresponding functional unit being maintained after the operator control element (24) is removed from the mounting point (13).

13. The apparatus according to claim 12, **characterized in that** the electrical appliance has only one single operator control element (24), with preferably all the mounting points (13) for the associated functional units being of identical design.

## Revendications

1. Procédé de commande d'un appareil électrique,
l'appareil électrique présentant plusieurs unités fonctionnelles, un panneau de commande (12) et au moins un élément de commande (24) à déplacement libre destiné à être placé sur le panneau de commande,
un emplacement de pose (13) repéré étant prévu sur le panneau de commande (12) pour chaque unité fonctionnelle, pour y placer l'élément de commande (24),
un détecteur (20) pour un commutateur de contact (52) ainsi qu'un détecteur (42) de détection de la rotation ou de la position de rotation de l'élément de commande (24) étant prévus en dessous de l'emplacement de pose (13),
le placement d'un élément de commande (24) sur un emplacement de pose (13) étant détecté et évalué comme branchement ou activation de l'unité fonctionnelle associée et une rotation ultérieure de l'élément de commande (24) étant détectée et ayant pour effet une modification de l'état de fonctionnement de l'unité fonctionnelle,
l'état de fonctionnement de l'unité fonctionnelle correspondante étant maintenu après l'enlèvement de l'élément de commande (24) hors de l'emplacement de pose (13).

2. Procédé selon la revendication 1, **caractérisé en ce que** le placement d'un doigt (11) sur un emplacement de pose (13) sur lequel n'est placé aucun élément de commande (24) est détecté et l'unité fonctionnelle associée est débranchée.

3. Procédé selon les revendications 1 ou 2, **caractérisé en ce que** l'élément de commande (24) présente des moyens de détection (52) dont l'actionnement est détecté par des détecteurs (20) situés en dessous de l'emplacement de pose (13) lorsque l'élément de commande y est placé.

4. Procédé selon la revendication 3, **caractérisé en ce qu'**une modification de l'état de fonctionnement de l'unité fonctionnelle associée à l'emplacement de pose (13) est rendue possible ou est lancée uniquement après l'actionnement du moyen de détection (52).

5. Procédé selon les revendications 3 ou 4, **caractérisé en ce qu'**après que l'élément de commande (24) a été placé sur un emplacement de pose (13), l'actionnement du moyen de détection (52) doit avoir lieu à l'intérieur d'une durée prédéterminée d'au plus 10 secondes et de préférence d'au plus 5 secondes pour que l'état de fonctionnement de l'unité fonctionnelle associée puisse ensuite être modifié, l'unité fonctionnelle associée étant sinon débranchée.

6. Procédé selon l'une des revendications 3 à 5, **caractérisé en ce qu'**un nouvel actionnement du moyen de détection (52) débranche l'unité fonctionnelle associée lorsque l'élément de commande (24) est placé sur un emplacement de pose (13).

7. Procédé selon l'une des revendications précédentes, **caractérisé en ce que** l'appareil électrique présente un seul élément de commande (24), tous les emplacements de pose (13) ayant de préférence la même configuration pour toutes les unités fonctionnelles.

8. Procédé selon l'une des revendications précédentes, **caractérisé en ce que** l'appareil électrique est une table de cuisson présentant plusieurs emplacements de cuisson.

9. Procédé selon l'une des revendications précédentes, **caractérisé en ce qu'**après que l'élément de commande (24) a été placé sur un emplacement de pose (13), un déplacement ou une rotation de l'élément de commande (24) doit avoir lieu à l'intérieur d'une durée prédéterminée d'au plus 10 secondes et de préférence d'au plus 5 secondes pour que l'état de fonctionnement de l'unité fonctionnelle associée puisse ensuite être modifié, l'unité fonctionnelle associée étant sinon débranchée.

10. Procédé selon l'une des revendications précédentes, **caractérisé en ce que** pour un emplacement de commande (13), une horloge est lancée pour une unité fonctionnelle lorsqu'un élément de commande (24) placé sur cet emplacement de pose (13), l'emplacement de pose (13) prévu pour cette unité fonctionnelle passant en mode horloge pour permettre l'introduction d'une donnée d'horloge par actionnement d'un moyen de détection de commutation, en particulier un commutateur de contact (16) prévu sur le panneau de commande (12).

11. Procédé selon l'une des revendications précédentes, **caractérisé en ce que** le réglage du fonctionnement et l'état du fonctionnement sont maintenus après l'enlèvement de l'élément de commande (24) d'un emplacement de pose (13) et **en ce qu'**au cas où l'élément de commande (24) n'est pas placé sur un autre emplacement de pose (13) après une durée prédéterminée qui est de préférence de 3 à 20 secondes, la situation est détectée comme défaut ou souhait de débranchement et de blocage de l'appareil et l'appareil est débranché.

12. Dispositif en vue de l'exécution du procédé selon l'une des revendications précédentes,
l'appareil électrique présentant plusieurs unités fonctionnelles et le dispositif présentant une commande (57), un panneau de commande (12) et au moins un élément de commande (24) déplaçable librement et destiné à être placé sur le panneau de commande,
un emplacement de pose (13) marqué étant prévu sur le panneau de commande (12) pour chaque unité de commande en vue d'y placer l'élément de commande (24),
un détecteur (20) pour un commutateur de contact ainsi qu'un détecteur (42) détectant la rotation ou la position de rotation de l'élément de commande étant prévus sur ou en dessous de l'emplacement de commande (13),
les détecteurs (20, 42) et la commande (57) étant configurés pour détecter le placement d'un élément de commande (24) sur un emplacement de pose (13), pour brancher ou activer l'unité fonctionnelle associée ainsi que pour détecter ensuite la rotation de l'élément de commande (24) pour faire réaliser par la commande une modification de l'état de fonctionnement de l'unité fonctionnelle,
l'état de fonctionnement de l'unité fonctionnelle correspondante étant maintenu après l'enlèvement de l'élément de commande (24) hors de l'emplacement de pose (13).

13. Dispositif selon la revendication 12, **caractérisé en ce que** l'appareil électrique présente un seul élément de commande (24) , tous les emplacements de pose (13) prévus pour les unités fonctionnelles associées ayant de préférence la même configuration.
